(19) Europäisches Patentamt
European Patent Office
Office européen des brevets

(11) EP 4 675 920 A1

(12) EUROPEAN PATENT APPLICATION

(43) Date of publication:
07.01.2026 Bulletin 2026/02

(21) Application number: 25187374.1

(22) Date of filing: 03.07.2025

(51) International Patent Classification (IPC):
H03F 3/45 (2006.01)   H03F 3/26 (2006.01)

(52) Cooperative Patent Classification (CPC):
H03F 3/265; H03F 3/45179; H03F 3/45475;
H03F 3/45632; H03F 3/45928; H03F 2203/45008;
H03F 2203/45134; H03F 2203/45151;
H03F 2203/45418; H03F 2203/45594;
H03F 2203/45596; H03F 2203/45694;
H03F 2203/45696; H03F 2203/45718

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 05.07.2024 US 202463667847 P
01.07.2025 US 202519257428

(71) Applicant: MEDIATEK INC.
Hsinchu City 30078 (TW)

(72) Inventors:
• PARK, Henry Arnold
San Jose, CA, 95134 (US)
• NEHAL, Qaiser
San Jose, CA, 95134 (US)
• ALI, Tamer Mohammed
San Jose, CA, 95134 (US)

(74) Representative: Pfenning, Meinig & Partner mbB
Patent- und Rechtsanwälte
Joachimsthaler Straße 10-12
10719 Berlin (DE)

(54) MULTI-STAGE AMPLIFIER USING AREA-EFFICIENT AND POWER-EFFICIENT COMMON-MODE TERMINATION TECHNIQUE

(57) A multi-stage amplifier (100) includes a plurality of single-stage differential amplifiers (102, 104) that are connected in a cascade arrangement. The single-stage differential amplifiers (102, 104) include a first single-stage differential amplifier (102) and a second single-stage differential amplifier (104). The first single-stage differential amplifier (102) has a first output network (116). The second single-stage differential amplifier (104) has a second output network (126). A common-mode (CM) node of the second output network (126) is shorted to a CM node of the first output network (116).

FIG. 1

**Description**

Field of the Invention

The present invention relates to an amplifier design, and more particularly, to a multi-stage amplifier using an area-efficient and power-efficient common-mode termination technique.

Background of the Invention

The output from a single-stage amplifier is usually insufficient to drive a load device. Specifically, the gain of the single-stage amplifier is inadequate for practical purposes. Consequently, additional amplification over more stages is necessary. Hence, a multi-stage amplifier having multiple amplifiers connected in a cascade arrangement is proposed. In a case where the multi-stage amplifier is a fully-differential multi-stage amplifier, the multi-stage amplifier may experience large common-mode (CM) disturbances due to certain factors. For example, a differential input of the multi-stage amplifier may be offset by a CM signal, resulting in nonlinear distortion and performance degradation. One conventional CM termination technique is to use a large-sized CM termination capacitor, causing an area penalty to the multi-stage amplifier design. Another conventional CM termination technique is to use a power-hungry operation amplifier (OP-AMP) buffer with a very low impedance (virtual ground), causing a power penalty to the multi-stage amplifier design. Thus, an innovative area-efficient and power-efficient CM termination technique for a multi-stage amplifier is needed.

Summary of the Invention

The scope of the present invention is defined by the claims.

This in mind, the present invention aims at providing a multi-stage amplifier using an area-efficient and power-efficient common-mode termination technique.

This is achieved by a multi-stage amplifier according to the independent claim. The dependent claims pertain to corresponding further developments and improvements.

As will be seen more clearly from the detailed description following below, the claimed multi-stage amplifier includes a plurality of single-stage differential amplifiers that are connected in a cascade arrangement. The single-stage differential amplifiers include a first single-stage differential amplifier and a second single-stage differential amplifier. The first single-stage differential amplifier has a first output network. The second single-stage differential amplifier has a second output network. A common-mode (CM) node of the second output network is shorted to a CM node of the first output network.

Brief Description of the Drawings

In the following, the invention is further illustrated by way of example, taking reference to the accompanying drawings. Thereof

     FIG. 1 is a diagram illustrating a first multi-stage amplifier using the proposed area-efficient and power-efficient common-mode termination technique according to an embodiment of the present invention,
FIG. 2 is a diagram illustrating a common-mode (CM) model of the multi-stage amplifier shown in FIG. 1 according to an embodiment of the present invention,
FIG. 3 is a diagram illustrating an equivalent circuit of a low-frequency approximation of the multi-stage amplifier shown in FIG. 1 according to an embodiment of the present invention,
FIG. 4 is a diagram illustrating a second multi-stage amplifier using the proposed area-efficient and power-efficient common-mode termination technique according to an embodiment of the present invention, and
FIG. 5 is a diagram illustrating an equivalent circuit of a low-frequency approximation of the multi-stage amplifier shown in FIG. 4 according to an embodiment of the present invention.

Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

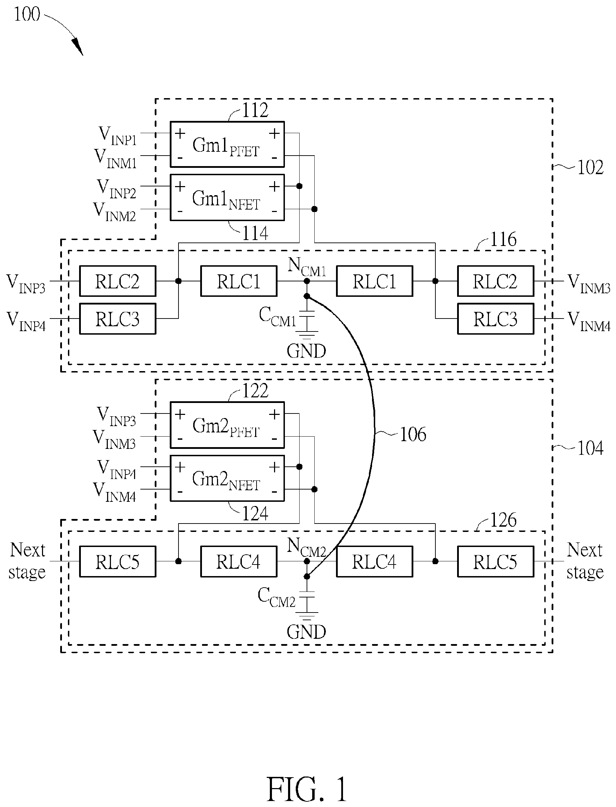

FIG. 1 is a diagram illustrating a first multi-stage amplifier using the proposed area-efficient and power-efficient common-mode (CM) termination technique according to an embodiment of the present invention. The multi-stage amplifier 100 may be included in a wireline receiver. However, this is for illustrative purposes only, and is not meant to be a limitation of the present invention. In practice, any application using the multi-stage amplifier 100 with a CM gain significantly suppressed by the proposed CM termination technique falls within the scope of the present invention. In this embodiment, the multi-stage amplifier 100 is a 2-stage amplifier including two single-stage differential amplifiers 102, 104 and a shorting path 106, where the single-stage differential amplifiers 102 and 104 are connected in a cascade arrangement.

The single-stage differential amplifier 102 acts as an input stage amplifier of the multi-stage amplifier 100, and employs a push-pull amplifier structure. Hence, the single-stage differential amplifier 102 may have two transconductance (Gm) cells 112 and 114. The Gm cell 112 is implemented using a pair of P-type metal-oxide-semiconductor (PMOS) transistors, and has transconductance $Gm1_{PFET}$. A gate terminal of one PMOS transistor of the Gm cell 112 is configured to receive a positive input signal $V_{INP1}$ of a differential voltage input ($V_{INP1}$, $V_{INM1}$), and a gate terminal of the other PMOS transistor of the transconductance cell 112 is configured to receive a negative input signal $V_{INM1}$ of the differential voltage input ($V_{INP1}$, $V_{INM1}$). The Gm cell 114 is implemented using a pair of N-type metal-oxide-semiconductor (NMOS) transistors, and has transconductance $Gm1_{NFET}$. A gate terminal of one NMOS transistor of the Gm cell 114 is configured to receive a positive input signal $V_{INP2}$ of a differential voltage input ($V_{INP2}$, $V_{INM2}$), and a gate terminal of the other NMOS transistor of the Gm cell 114 is configured to receive a negative input signal $V_{INM2}$ of the differential voltage input ($V_{INP2}$, $V_{INM2}$). Due to inherent characteristics of the push-pull amplifier structure, the positive input signals $V_{INP1}$ and $V_{INP2}$ may be both derived from a positive input signal of a differential voltage input of the multi-stage amplifier 100, and the negative input signals $V_{INM1}$ and $V_{INM2}$ may be both derived from a negative input signal of the differential voltage input of the multi-stage amplifier 100.

The single-stage differential amplifier 102 further includes an output network 116. The output network 116 is configured to receive differential current outputs of the 1st-stage Gm cells 112 and 114, and provide differential voltage outputs as different voltage inputs ($V_{INP3}$, $V_{INM3}$) and ($V_{INP4}$, $V_{INM4}$) of a next stage (i.e., 2nd stage of multi-stage amplifier 100). The output network 116 may include a plurality of passive devices RLC1, RLC2, RLC3 arranged in a symmetrical arrangement centered at a CM node $N_{CM1}$, where each of the passive devices may include a resistor (R), a capacitor (C), an inductor (L), or a combination thereof.

The single-stage differential amplifier 104 acts as an output stage amplifier of the multi-stage amplifier 100, and employs a push-pull amplifier structure. Hence, the single-stage differential amplifier 104 may have two Gm cells 122 and 124. The Gm cell 122 is implemented using a pair of PMOS transistors, and has transconductance $Gm2_{PFET}$. A gate terminal of one PMOS transistor of the Gm cell 122 is configured to receive a positive input signal $V_{INP3}$ of the differential voltage input ($V_{INP3}$, $V_{INM3}$) output from the previous stage (i.e., 1st stage of multi-stage amplifier 100), and a gate terminal of the other PMOS transistor of the Gm cell 122 is configured to receive a negative input signal $V_{INM3}$ of the differential voltage input ($V_{INP3}$, $V_{INM3}$) output from the previous stage (i.e., 1st stage of multi-stage amplifier 100). The Gm cell 124 is implemented using a pair of NMOS transistors, and has transconductance $Gm2_{NFET}$. A gate terminal of one NMOS transistor of the Gm cell 124 is configured to receive a positive input signal $V_{INP4}$ of the differential voltage input ($V_{INP4}$, $V_{INM4}$) output from the previous stage (i.e., 1st stage of multi-stage amplifier 100), and a gate terminal of the other NMOS transistor of the Gm cell 124 is configured to receive a negative input signal $V_{INM4}$ of the differential voltage input ($V_{INP4}$, $V_{INM4}$) output from the previous stage (i.e., 1st stage of multi-stage amplifier 100). Due to inherent characteristics of the push-pull amplifier structure, the positive input signals $V_{INP3}$ and $V_{INP4}$ may be both derived from a positive output signal of a differential current output of the 1st-stage Gm cells 112, 114, and the negative input signals $V_{INM3}$ and $V_{INM4}$ may be both derived from a negative output signal of the differential current output of the 1st-stage Gm cells 112, 114.

The single-stage differential amplifier 104 further includes an output network 126. The output network 126 is configured to receive differential current outputs of the 2nd-stage Gm cells 122 and 124, and provide voltage outputs to a next stage following the multi-stage amplifier 100. The output network 126 may include a plurality of passive devices RLC4, RLC5 arranged in a symmetrical arrangement centered at a CM node $N_{CM2}$, where each of the passive devices may include a resistor (R), a capacitor (C), an inductor (L), or a combination thereof.

It should be noted that the fully differential amplifier structure of each stage as shown in FIG. 1 is for illustrative purposes only, and is not meant to be a limitation of the present invention. In practice, the present invention has no limitations on actual implementation of the fully differential amplifier structure of each stage, and any multi-stage amplifier with a CM gain significantly suppressed by using the proposed CM termination technique falls within the scope of the present invention.

In accordance with the proposed area-efficient and power-efficient common-mode termination technique, the CM node $N_{CM2}$ of the output network 126 (i.e., 2nd-stage center tap) is shorted to the CM node $N_{CM1}$ of the output network 116 (i.e., 1st-stage center tap). For example, the CM node $N_{CM1}$ of the output network 116 and the CM node $N_{CM2}$ of the output network 126 are connected together through the shorting path 106 that may be simply implemented using a routing trace. Since the CM node $N_{CM2}$ of the output network 126 is shorted to the CM node $N_{CM1}$ of the output network 116, the capacitive CM termination $C_{CM1}/C_{CM2}$ is allowed to be implemented using a small-sized capacitor or may be omitted. For example, the capacitive CM termination $C_{CM1}$ may be implemented by a capacitor with low capacitance (e.g., $0 < C_{CM1} < 100pF$) coupled between the CM node $N_{CM1}$ of the output network 116 and a ground voltage GND, or the capacitive CM termination $C_{CM1}$ may be replaced by a short-circuit (e.g., $C_{CM1}$=0) between the CM node $N_{CM1}$ of the output network 116 and the ground voltage GND. For another example, the capacitive CM termination $C_{CM2}$ may be implemented by a capacitor with low capacitance (e.g., 0<$C_{CM2}$<100pF) coupled between the CM node $N_{CM2}$ of the output network 126 and the ground voltage GND, or the capacitive CM termination $C_{CM2}$ may be replaced by a short-circuit (e.g., $C_{CM2}$=0) between the CM node $N_{CM2}$ of the output network 126 and the ground voltage GND.

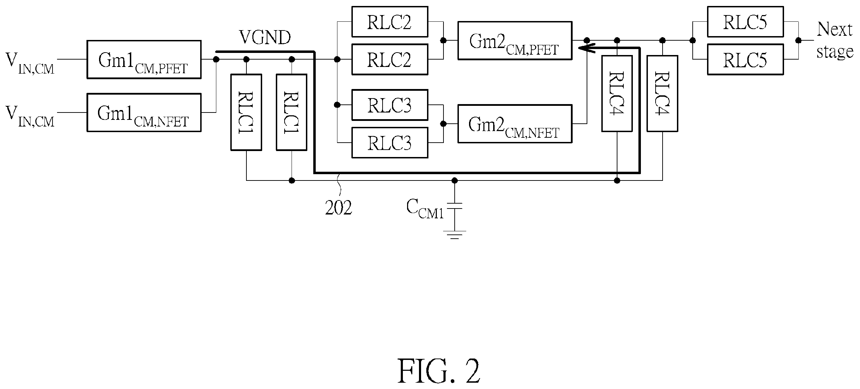

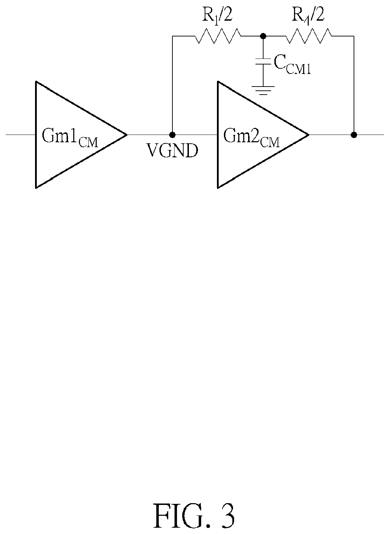

Please refer to FIG. 2 in conjunction with FIG. 3. FIG. 2 is a diagram illustrating a CM model of the multi-stage amplifier 100 shown in FIG. 1 according to an embodiment of the present invention. FIG. 3 is a diagram illustrating an equivalent circuit of a low-frequency approximation of the multi-stage amplifier 100 shown in FIG. 1 according to an embodiment of the present invention. As shown in FIG. 2, the same CM signal $V_{IN,CM}$ is received by the Gm cells 112 and 114. Since the CM node $N_{CM2}$ of the output network 126 is shorted to the CM node $N_{CM1}$ of the output network 116, a CM current path 202 is from output nodes of 1st-stage Gm cells 112, 114 to output nodes of 2nd-stage Gm cells 122, 124 through parallel-connected passive devices RLC1 and parallel-connected passive devices RLC4. The output nodes of Gm cells 112, 114 may be roughly a virtual ground VGND. As shown in FIG. 3, the single-stage differential amplifier (i.e., 1st-stage amplifier) 102 has a CM gain $Gm1_{CM}$, and the single-stage differential amplifier (i.e., 2nd-stage amplifier) 104 has a CM gain $Gm2_{CM}$. In this embodiment, the CM gain $Gm2_{CM}$ of the single-stage differential amplifier 104 may be constrained to be negative. Hence, the Gm cells 122, 124 of the single-stage differential amplifier (i.e., 2nd-stage amplifier) 104 can be reused to create a negative feedback loop as well as low impedance at output nodes of the Gm cells 112, 114 of the single-stage differential amplifier (i.e., 1st-stage amplifier) 102, thereby steering the CM current from the 1st-stage Gm cells through multi-stage output networks and the shorting path.

As shown in FIG. 3, the multi-stage amplifier 100 has a negative CM gain $-Gm1_{CM} \times (\frac{R_1}{2} + \frac{R_4}{2})$, where $R_1$ is an impedance value of each of the parallel-connected passive devices RLC1, and $R_2$ is an impedance value of each of the parallel-connected passive devices RLC4. A conventional 2-stage amplifier has a positive CM gain $(Gm1_{CM} \times \frac{R_1}{2}) \times (Gm2_{CM} \times \frac{R_4}{2}) \cong (Gm_{CM} \times R)^2$. Hence, the proposed CM termination technique is capable of significantly suppressing the CM gain by shorting CM nodes $N_{CM1}$ and $N_{CM2}$ of two stages. Since the CM gain is no longer limited by the capacitive CM termination, the multi-stage amplifier 100 is allowed to use weak capacitive CM termination (e.g., $C_{CM1}$<100pF or $C_{CM2}$<100pF) or omit the capacitive CM termination (e.g., $C_{CM1}$=0 or $C_{CM2}$=0). The proposed CM termination technique is an area-efficient solution. In addition, the proposed CM termination technique can be simply implemented by using a routing trace. Hence, there is no need of an extra power-hungry operational amplifier to drive the CM node at low impedance. The proposed CM termination technique is also a power-efficient solution.

Regarding the embodiment shown in FIG. 1, the proposed CM termination technique is employed by a 2-stage amplifier. However, this is for illustrative purposes only, and is not meant to be a limitation of the present invention. In practice, the proposed CM termination technique can be applied to any arbitrary number of stages. That is, an N-stage amplifier can employ the proposed CM termination technique to have a CM node of an output network of one single-stage differential amplifier (e.g., input-stage amplifier) and a CM node of an output network of another single-stage differential amplifier (e.g., output-stage amplifier) connected together for achieving a significantly suppressed CM gain, where N ≥ 2.

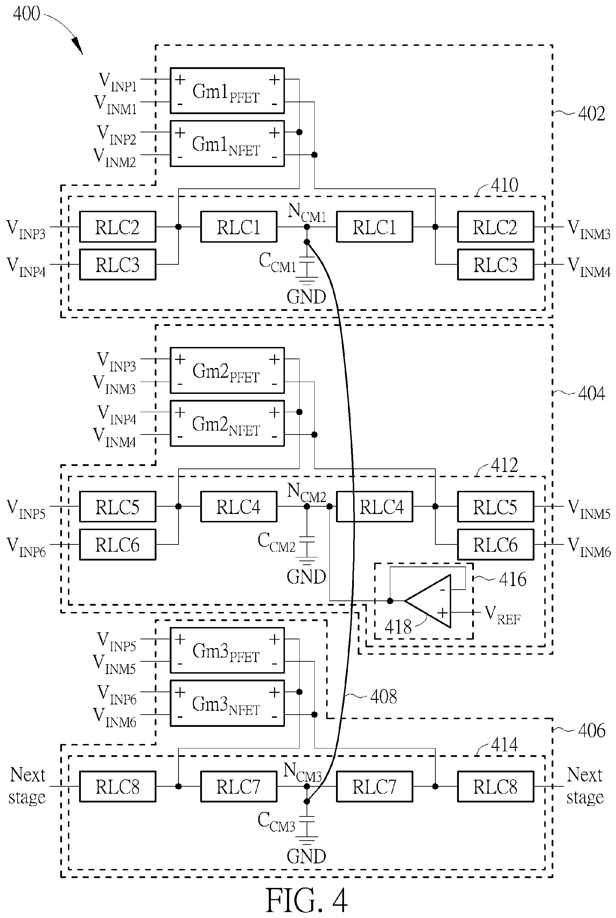

FIG. 4 is a diagram illustrating a second multi-stage amplifier using the proposed area-efficient and power-efficient common-mode termination technique according to an embodiment of the present invention. The multi-stage amplifier 400 may be included in a wireline receiver. However, this is for illustrative purposes only, and is not meant to be a limitation of the present invention. In practice, any application using the multi-stage amplifier 400 with a CM gain significantly suppressed by the proposed CM termination technique falls within the scope of the present invention. In this embodiment, the multi-stage amplifier 400 is a 3-stage amplifier including three single-stage differential amplifiers 402, 404, 406 and a shorting path 408, where the single-stage differential amplifiers 402, 404, and 406 are connected in a cascade arrangement, the single-stage differential amplifier 402 acts as an input stage amplifier of the multi-stage amplifier 400, the single-stage differential amplifier 404 acts as an intermediate stage amplifier of the multi-stage amplifier 400, and the single-stage differential amplifier 406 acts as an output stage amplifier of the multi-stage amplifier 400. Each of the single-stage differential amplifiers 402, 404, 406 may employ a push-pull amplifier structure. Hence, the single-stage differential amplifier 402 has two Gm cells with transconductance $Gm1_{PFET}$ and $Gm1_{NFET}$ for processing differential voltage inputs ($V_{INP1}$, $V_{INM1}$) and ($V_{INP2}$, $V_{INM2}$), the single-stage differential amplifier 404 has two Gm cells with transconductance $Gm2_{PFET}$ and $Gm2_{NFET}$ for processing differential voltage inputs ($V_{INP3}$, $V_{INM3}$) and ($V_{INP4}$, $V_{INM4}$), and the single-stage differential amplifier 406 has two Gm cells with transconductance $Gm3_{PFET}$ and $Gm3_{NFET}$ for processing differential voltage inputs ($V_{INP5}$, $V_{INM5}$) and ($V_{INP6}$, $V_{INM6}$).

The single-stage differential amplifier 402 further includes an output network 410 that is configured to receive differential current outputs of the 1st-stage Gm cells and provide differential voltage outputs as different voltage inputs of a next stage (i.e., 2nd stage of multi-stage amplifier 400). The output network 410 may include a plurality of passive devices RLC1, RLC2, RLC3 arranged in a symmetrical arrangement centered at a CM node $N_{CM1}$, where each of the passive devices may include a resistor (R), a capacitor (C), an inductor (L), or a combination thereof.

The single-stage differential amplifier 404 further includes an output network 412 that is configured to receive differential current outputs of the 2nd-stage Gm cells and provide differential voltage outputs as different voltage inputs of a next stage (i.e., 3rd stage of multi-stage amplifier 400). The output network 412 may include a plurality of passive devices RLC4, RLC5, RLC6 arranged in a symmetrical arrangement centered at a CM node $N_{CM2}$, where each of the passive devices may include a resistor (R), a capacitor (C), an inductor (L), or a combination thereof.

The single-stage differential amplifier 406 further includes an output network 414 that is configured to receive differential current outputs of the 3rd-stage Gm cells and provide voltage outputs to a next stage following the multi-stage amplifier 400. The output network 414 may include a plurality of passive devices RLC7, RLC8 arranged in a symmetrical arrangement centered at a CM node $N_{CM3}$, where each of the passive devices may include a resistor (R), a capacitor (C), an inductor (L), or a combination thereof.

It should be noted that the fully differential amplifier structure of each stage as shown in FIG. 4 is for illustrative purposes only, and is not meant to be a limitation of the present invention. In practice, the present invention has no limitations on actual implementation of the fully differential amplifier structure of each stage, and any multi-stage amplifier with a CM gain significantly suppressed by using the proposed CM termination technique falls within the scope of the present invention.

In accordance with the proposed area-efficient and power-efficient common-mode termination technique, the CM node $N_{CM3}$ of the output network 414 (i.e., 3rd-stage center tap) is shorted to the CM node $N_{CM1}$ of the output network 410 (i.e., 1st-stage center tap). For example, the CM node $N_{CM1}$ of the output network 410 and the CM node $N_{CM3}$ of the output network 414 are connected together through the shorting path 408 that may be simply implemented using a routing trace. Since the CM node $N_{CM3}$ of the output network 414 is shorted to the CM node $N_{CM1}$ of the output network 410, the capacitive CM termination $C_{CM1}/C_{CM3}$ is allowed to be implemented using a small-sized capacitor or may be omitted. For example, the capacitive CM termination $C_{CM1}$ may be implemented by a capacitor with low capacitance (e.g., $0<C_{CM1}<100pF$) coupled between the CM node $N_{CM1}$ of the output network 410 and a ground voltage GND, or the capacitive CM termination $C_{CM1}$ may be replaced by a short-circuit (e.g., $C_{CM1}=0$) between the CM node $N_{CM1}$ of the output network 410 and the ground voltage GND. For another example, the capacitive CM termination

$C_{CM3}$ may be implemented by a capacitor with low capacitance (e.g., $0<C_{CM3}<100pF$) coupled between the CM node $N_{CM3}$ of the output network 414 and the ground voltage GND, or the capacitive CM termination $C_{CM3}$ may be replaced by a short-circuit (e.g., $C_{CM2}=0$) coupled between the CM node $N_{CM3}$ of the output network 414 and the ground voltage GND.

Regarding the CM termination coupled to the CM node $N_{CM2}$ of the output network 412, it may be implemented using a capacitive termination, a low impedance buffer, or both. As shown in FIG. 4, one capacitive CM termination $C_{CM2}$ (e.g., large-sized capacitor) is coupled between the CM node $N_{CM2}$ of the output network 412 and the ground voltage GND to provide a low-impedance current path for the unwanted CM signal, and one buffer circuit 416 is coupled to the CM node $N_{CM2}$ of the output network 412 for driving the CM node $N_{CM2}$ at low impedance. For example, the buffer circuit 416 may be implemented using an operation amplifier (OP-AMP) 418 that is configured as a source follower with low output impedance.

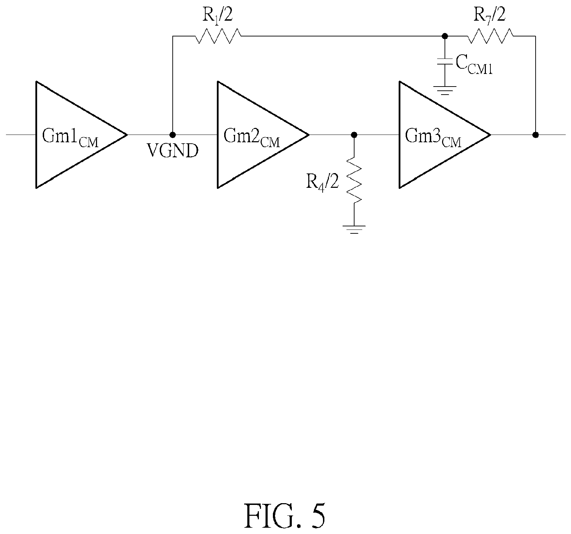

FIG. 5 is a diagram illustrating an equivalent circuit of a low-frequency approximation of the multi-stage amplifier 400 shown in FIG. 4 according to an embodiment of the present invention. Since the CM node $N_{CM3}$ of the output network 414 is shorted to the CM node $N_{CM1}$ of the output network 410, a CM current path is from output nodes of 1st-stage Gm cells to output nodes of 3rd-stage Gm cells through parallel-connected passive devices RLC1 and parallel-connected passive devices RLC7. The output nodes of 1st-stage Gm cells may be roughly a virtual ground VGND. As shown in FIG. 5, the single-stage differential amplifier (i.e., 1st-stage amplifier) 402 has a CM gain $Gm1_{CM}$, the single-stage differential amplifier (i.e., 2nd-stage amplifier) 404 has a CM gain $Gm2_{CM}$, and the single-stage differential amplifier 406 has a CM gain $Gm3_{CM}$. In this embodiment, a product of the CM gain $Gm2_{CM}$ of the single-stage differential amplifier 404 and the CM gain $Gm3_{CM}$ of the single-stage differential amplifier 406 is constrained to be negative, that is, $(Gm1_{CM} \times Gm3_{CM}) < 0$. For example, one of the CM gains $Gm2_{CM}$ and $Gm3_{CM}$ may be a negative CM gain, and the other of the CM gains $Gm2_{CM}$ and $Gm3_{CM}$ may be a positive CM gain. Hence, the Gm cells of the single-stage differential amplifier (i.e., 2nd-stage amplifier) 404 and the Gm cells of the single-stage differential amplifier (i.e., 3nd-stage amplifier) 406 can be reused to create a negative feedback loop as well as low impedance at output nodes of the Gm cells of the single-stage differential amplifier (i.e., 1st-stage amplifier) 402, thereby steering the CM current from the 1st-stage Gm cells through multi-stage output networks and the shorting path.

As shown in FIG. 5, the multi-stage amplifier 400 has a negative CM gain $$-Gm1_{CM} \times (\frac{R_1}{2} +$$

$\frac{R_7}{2})$ , where $R_1$ is an impedance value of each of the parallel-connected passive devices RLC1, and $R_7$ is an impedance value of each of the parallel-connected passive devices RLC7. A conventional 3-stage amplifier has a positive CM gain

$$(\text{Gm1}_{CM} \times \frac{R_1}{2}) \times (\text{Gm2}_{CM} \times \frac{R_4}{2}) \times$$

$$(\text{Gm3}_{CM} \times \frac{R_7}{2}) \cong (\text{Gm}_{CM} \times R)^3$$

. Hence, the proposed CM termination technique is capable of significantly suppressing the CM gain by shorting CM nodes $N_{CM1}$ and $N_{CM3}$ of two stages. Since the CM gain is no longer limited by the capacitive CM termination, the multi-stage amplifier 400 is allowed to use weak capacitive CM termination (e.g., $C_{CM1}<100pF$ and/or $C_{CM3}<100pF$) or omit the capacitive CM termination (e.g., $C_{CM1}=0$ and/or $C_{CM3}=0$). The proposed CM termination technique is an area-efficient solution. In addition, the proposed CM termination technique can be simply implemented by using a routing trace. Hence, there is no need of an extra power-hungry operational amplifier to drive the CM node at low impedance. The proposed CM termination technique is also a power-efficient solution.

**Claims**

1. A multi-stage amplifier (100, 400) **characterized by**:
a plurality of single-stage differential amplifiers (102, 104, 402, 404, 406), connected in a cascade arrangement, wherein the plurality of single-stage differential amplifiers (102, 104, 402, 404, 406) comprise:

   a first single-stage differential amplifier (102, 402), comprising a first output network (116, 410); and
   a second single-stage differential amplifier (104, 406), comprising a second output network (126, 414), wherein a common-mode, hereinafter referred to as CM, node of the second output network (126, 414) is shorted to a CM node of the first output network (116, 410).

2. The multi-stage amplifier (100, 400) of claim 1, **characterized in that** the multi-stage amplifier (100, 400) further comprises:
a routing trace (106, 408), coupled between the CM node of the first output network (116, 410) and the CM node of the second output network (126, 414).

3. The multi-stage amplifier (100, 400) of any one of claims 1 or 2, **characterized in that** the first single-stage differential amplifier (102, 402) is an input stage amplifier of the multi-stage amplifier (100, 400), and the second single-stage differential amplifier (104, 406) is an output stage amplifier of the multi-stage amplifier (100, 400).

4. The multi-stage amplifier (100) of any one of claims 1 to 3, **characterized in that** the multi-stage amplifier (100) is an N-stage amplifier circuit, where N is equal to 2.

5. The multi-stage amplifier (100) of claim 4, **characterized in that** a CM gain of the second single-stage differential amplifier (104) is negative.

6. The multi-stage amplifier (400) of any one of claims 1 to 3, **characterized in that** the multi-stage amplifier (400) is an N-stage amplifier circuit, the first single-stage differential amplifier (402) is a 1st-stage amplifier of the multi-stage amplifier, and the second single-stage differential amplifier (406) is an Nth-stage amplifier of the multi-stage amplifier, where N is larger than 2.

7. The multi-stage amplifier (400) of claim 6, **characterized in that** a product of CM gains of a 2nd-stage amplifier (404) to the Nth-stage amplifier (406) of the multi-stage amplifier (400) is negative.

8. The multi-stage amplifier (100, 400) of any of claims 4 to 6, **characterized in that** the first output network (116, 410) comprises a capacitive CM termination coupled between the CM node of the first output network (116, 410) and a ground voltage.

9. The multi-stage amplifier (100, 400) of any of claims 4 to 6, **characterized in that** the CM node of the first output network (116, 410) is shorted to a ground voltage.

10. The multi-stage amplifier (100, 400) of any of claims 4 to 6, **characterized in that** the second output network (126, 414) comprises a capacitive CM termination coupled between the CM node of the second output network (126, 414) and a ground voltage.

11. The multi-stage amplifier (100, 400) of any of claims 4 to 6, **characterized in that** the CM node of the second output network (126, 414) is shorted to a ground voltage.

12. The multi-stage amplifier (400) of any one of claims 6 to 11, **characterized in that** the plurality of single-stage differential amplifiers further comprise:
a third single-stage differential amplifier (404), comprising a third output network (412), wherein the third output network (412) comprises a capacitive CM termination coupled between a CM node of the third output network (412) and a ground voltage.

13. The multi-stage amplifier (400) of any one of claims 6 to 12, **characterized in that** the plurality of single-stage differential amplifiers further comprise:
a third single-stage differential amplifier (404), comprising a third output network (412), wherein the third output network (412) comprises a buffer circuit (416) coupled to a CM node of the third output network (412).

14. The multi-stage amplifier (100, 400) of any one of claims 1 to 13, **characterized in that** the multi-stage amplifier (100, 400) is included in a wireline receiver.

FIG. 1

FIG. 2

FIG. 3

FIG. 4

FIG. 5

**EUROPEAN SEARCH REPORT**

Application Number

EP 25 18 7374

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/293258 A1 (FANT ANDREA [IT] ET AL) 22 November 2012 (2012-11-22) * paragraph [0015] - paragraph [0028]; figures 1-5 * ----- | 1-14 | INV. H03F3/45 H03F3/26 |
| A | US 2023/170863 A1 (LABBE ERIC C [US] ET AL) 1 June 2023 (2023-06-01) * paragraph [0047] - paragraph [0058]; figure 1 * ----- | 1-14 | |

TECHNICAL FIELDS
SEARCHED      (IPC)

H03F

The present search report has been drawn up for all claims

| Place of search | Date of completion of the search | Examiner |
|---|---|---|
| The Hague | 25 November 2025 | Wienema, David |

EPO FORM 1503 03.82 (P04C01)

## ANNEX TO THE EUROPEAN SEARCH REPORT
## ON EUROPEAN PATENT APPLICATION NO.

EP 25 18 7374

This annex lists the patent family members relating to the patent documents cited in the above-mentioned European search report.
The members are as contained in the European Patent Office EDP file on
The European Patent Office is in no way liable for these particulars which are merely given for the purpose of information.

25-11-2025

| Patent document cited in search report | Publication date | Patent family member(s) | Publication date |
|---|---|---|---|
| US 2012293258 A1 | 22-11-2012 | DE 102012009835 A1<br>US 2012293258 A1 | 22-11-2012<br>22-11-2012 |
| US 2023170863 A1 | 01-06-2023 | NONE | |

EPO FORM P0459

For more details about this annex : see Official Journal of the European Patent Office, No. 12/82